(19) Europäisches Patentamt / European Patent Office / Office européen des brevets

(11) **EP 1 927 098 B1**

(12) **EUROPEAN PATENT SPECIFICATION**

(45) Date of publication and mention
of the grant of the patent:
**23.05.2018  Bulletin 2018/21**

(21) Application number: **06742563.7**

(22) Date of filing: **23.03.2006**

(51) Int Cl.:
*G09F 13/04* (2006.01)     *F21V 7/00* (2006.01)
*G02B 5/02* (2006.01)     *B60R 13/00* (2006.01)
*C08F 265/06* (2006.01)     *C08F 279/02* (2006.01)
*C08F 279/04* (2006.01)     *C08L 33/04* (2006.01)
*C08L 51/00* (2006.01)     *C08L 51/04* (2006.01)
*C08L 55/02* (2006.01)     *F21V 3/04* (2018.01)
*G02B 1/04* (2006.01)     *F21Y 115/10* (2016.01)

(86) International application number:
**PCT/EP2006/003310**

(87) International publication number:
**WO 2006/100127 (28.09.2006 Gazette 2006/39)**

(54) **ILLUMINATING DEVICE COMBINING A WHITE LED AND A DIFFUSING SHEET**

BELEUCHTUNGSEINRICHTUNG, DIE EINE WEISSE LED UND EIN DIFFUSIONSBLATT KOMBINIERT

DISPOSITIF ILLUMINE A DEL BLANCHE ET FEUILLE DE DIFFUSION

(84) Designated Contracting States:
**AT BE BG CH CY CZ DE DK EE ES FI FR GB GR HU IE IS IT LI LT LU LV MC NL PL PT RO SE SI SK TR**

(30) Priority: **25.03.2005  FR 0502985**
**02.06.2005  US 686841 P**

(43) Date of publication of application:
**04.06.2008  Bulletin 2008/23**

(73) Proprietor: **ARKEMA FRANCE**
**92700 Colombes (FR)**

(72) Inventor: **VLOTTES, Peter**
**NL-8862 LA Harlingen (NL)**

(56) References cited:
**DE-A1- 10 058 348     DE-A1- 10 308 704**
**US-A- 6 084 250**

## Description

The present invention relates to a luminous device, in particular an illuminated sign, comprising at least one white light-emitting diode and at least one cover made of a transparent plastic in which particles that scatter the light emitted by the light-emitting diode are dispersed.

Light-emitting diodes or LEDs are increasingly used in everyday life. They allow conventional artificial light sources, such as incandescent lamps and neon tubes, to be effectively replaced as they consume less electrical power and can operate at low voltages (12 V for example). Furthermore, they are more compact and have very long lifetimes, which may range up to 100 000 hours of operation. Although the discovery of red LEDs goes back to the 1960s, many years had to elapse before the appearance of LEDs having sufficient illumination and before the development of LEDs of different colours. At the present time, there are LEDs that emit in the red, the green or the blue, white LEDs, and LEDs that emit in the ultraviolet or infrared spectrum. Extensive research has also allowed the light power emitted by LEDs to be significantly increased. LEDs having a light flux in excess of 3-5 lumens (Lm) have already been marketed and certain recent developments suggest that this may reach 100 lumens.

Light devices that integrate one more LEDs are, for example, motor vehicle illumination devices (at the front or rear), indicating panels, luminous displays, spotlights, street lighting, illuminated signs, etc.

With regard to an illuminated sign, its role is to capture the attention of customers, users, consumers, passers-by, etc., and therefore it is to be as visible as possible, both during the day and at night. It is therefore necessary for the elements that the sign contains (these may be letters, numbers, symbols, figures, etc.) to be visible in the daytime but also at night, or in half-darkness, when the sign is illuminated. It is therefore necessary for the sign to have a high contrast both in the daytime and at night.

An illuminated sign consists of a light source and a cover made of a plastic whose function is to mask and protect the light source, while still ensuring good transmission of the light emitted by the light source. The cover also has the function of scattering the emitted light so that the illumination is softened and not dazzling. The scattering of the light emitted by the light source is achieved by dispersing scattering particles of organic or mineral nature in the plastic. The plastic of the cover may be coloured or may have decorative elements or patterns. The cover also often takes the form of a letter or any other sign.

Replacing a conventional light source with an LED results in a modification of the illumination. This is because an LED exhibits directional illumination whereas for example the illumination of a neon tube is from 0 to 360°. In addition, the emission spectrum of an LED is completely different from that of a conventional light source. The development of luminous devices incorporating one or more white LEDs with a luminous flux of greater than 3 Lm therefore requires the plastic cover of the illuminated sign to be adapted.

The Applicant, seeking to solve the problem, has developed a luminous device comprising at least one LED having a luminous flux of greater than 3 Lm and a cover made of a transparent plastic in which scattering particles with a content of 0.3 to 5% are dispersed, and having, when the LED is off, a luminosity L of less than 40, preferably less than 35, and when the LED is lit, a luminosity L of greater than 55, an a* value of between -7.5 and +7.5 and a b* value of between -7.5 and +7.5.

## [Prior art]

US 6 723 772 discloses a scattering composition comprising a transparent plastic, based on methyl methacrylate or styrene, and organic or mineral scattering particles. The particle content is between 0.1 and 20% by weight, or expressed differently between 1 and 500 g/m$^2$.

US 2004/0191550 discloses a sheet comprising a layer (A) composed of a resin based on methyl methacrylate and one or two layers (B) composed of a blend of a resin based on methyl methacrylate and a resin based on vinylidene fluoride. The sheet may contain organic or mineral scattering particles in the layer (A) and be illuminated by a neon lamp or by an LED.

US 2004/0255497 discloses an illuminated sign in which the letters of the sign are made of a transparent plastic that scatters light. It does not matter what the light source is - LED, neon tube, incandescent lamp, etc.

EP 1 369 224 discloses a coextruded sheet comprising at least two layers - a layer of a thermoplastic filled with organic scattering particles and a layer of a transparent thermoplastic. The sheet may be illuminated by an LED. Within the context of the present invention, the process for manufacturing the cover that is illuminated by the LED is simpler as the cover is not manufactured by coextrusion but by simple extrusion or else by the casting process in the case of PMMA. The cover according to the invention therefore has only a single layer.

WO 03/052315 discloses a luminous device that combines a cover made of a transparent plastic and a colour LED. The transparent plastic contains 1.5 to 2.5% by weight of BaSO$_4$ or polystyrene particles. In the case of crosslinked plastic particles, the content varies from 0.1 to 10% by weight. White LEDs are not described. In addition, the object of the invention is to ensure that an illuminated sign has the same colour when it is off and when it is lit.

DE 100 58 348 discloses a lamp body with inner light source and at least a semitransparent cover that id mattified. Not disclosed is a luminous device having a cover made of a transparent plastic that consist of only one layer and that comprises scattering particles.

US 6 084 250 discloses a with light emmiting diode. The white light emitting diode or device may comprises a transparent coating with phosphors. Not disclosed is a luminous device having a cover made of a transparent plastic that consist of only one layer and that comprises scattering particles.

DE 103 08 704 discloses a car headlight comprising a (transparent) optical scattering lens (16) after a (transparent) optical focusing lens. The scattering lens is an optical lens the scatters the light in a certain cone in direction of the street. The scattering is obtained by means of optical lenses. Not disclosed is a luminous device having a cover made of a transparent plastic that consist of only one layer and that comprises scattering particles

These documents do not refer to a luminous device comprising a white LED of high luminosity, greater than 3 Lm, and a cover made of a transparent plastic in which scattering particles with a content of 0.3 to 5% are dispersed and having, when the LED is off, a luminosity L of less than 40, preferably less than 35, and when the LED is lit, a luminosity L of greater than 55, an a* value of between -7.5 and +7.5 and a b* value of between -7.5 and +7.5.

**[Brief description of the invention]**

The invention relates to a luminous device according to claim 1. The invention relates to a luminous device, in particular an illuminated sign, comprising at least one white LED having a luminous flux of greater than 3 Lm, advantageously greater than 5 Lm, preferably greater than 10 Lm and even more preferably greater than 50 Lm, and a cover made of a transparent plastic in which scattering particles with a content of 0.3 to 5%, preferably 0.3 to 4%, are dispersed and having, when the LED is off, a luminosity L of less than 40, preferably less than 35, and when the LED is lit, a luminosity L of greater than 55, an a* value of between -5 and +5 and a b* value of between -5 and +5.

The invention will be more clearly understood on reading the following detailed description, from the non-limiting examples of embodiments thereof and on examining the appended figures.

**[Figures]**

Figure 1 shows the diagram of an LED **1.** This consists of an anode **2,** a cathode **3** and a conducting wire **4** which allow the semiconductor **5** to be powered, the semiconductor itself being placed on a light-reflecting dish **6.** A protective shell **7** made of a transparent plastic protects the semiconductor and transmits the emitted light.

Figure 2 shows the emission spectrum (relative intensity in % as a function of the wavelength in nm) characteristic of a colour LED.

Figure 3 shows the emission spectrum of a white LED (relative intensity in % as a function of the wavelength in nm) that uses the re-emission of a phosphorescent compound.

Figure 4 shows the typical radiation profile of an LED (relative intensity in % as a function of the angular displacement θ in °).

Figure 5 shows an example of a luminous device. This is a letter **8** of an illuminated sign illuminated by LEDs **1.** To simplify matters, the electrical power supply wires have not been shown in the figure. The letter A includes, on the front face, a cover **9** that transmits the light emitted by the LEDs, while masking and protecting the LEDs. The other faces of the letter **8,** for example the face **10,** are opaque.

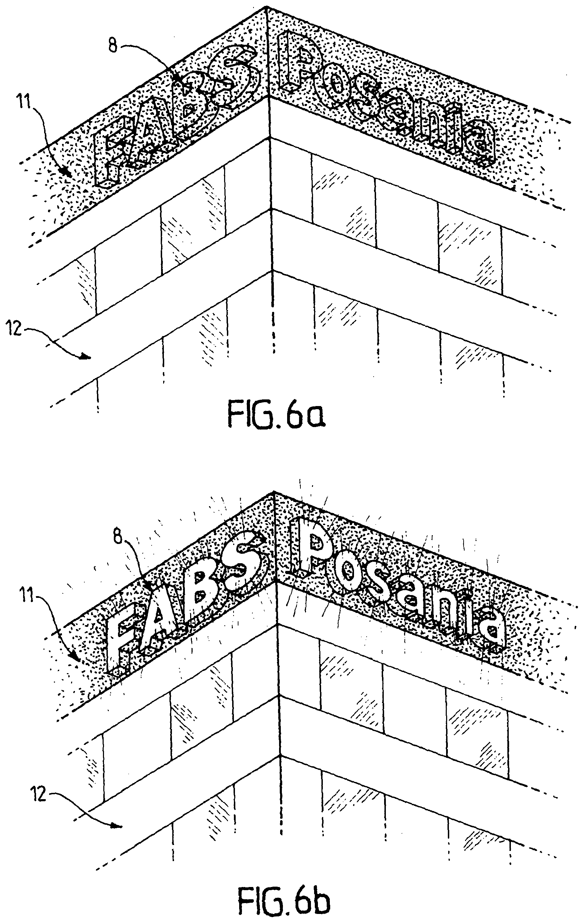

Figures 6a and 6b show an illuminated sign **11** at the top of a building **12.** Among the letters making up the sign is again the letter **8** of Figure 5, described above. Figure 6a shows the sign during the daytime when it is not lit. Figure 6b shows the sign at night, when it is lit.

**[Detailed description]**

The term "transparent plastic" denotes a plastic of thermoplastic or thermosetting type, having a light transmission in the visible range of at least 50%, preferably at least 70% and even more preferably at least 80% according to the DIN 67-507 standard (this is the light transmission of the transparent plastic with no scattering particle; when the scattering particles are dispersed in the transparent plastic, the transparency decreases). The transparent plastic is chosen from crystal polystyrene, polyethylene terephthalate (PET), a transparent, especially clarified, polyolefin, for example clarified polypropylene, PMMA, a transparent polyamide or polycarbonate.

PMMA and polycarbonate are the two transparent plastics of choice because they are easy to process, are commercially available and have a high transparency. In addition, these two plastics exhibit excellent thermomechanical strength, allowing compact luminous devices to be produced. This is because, although the energy efficiency of an LED (that is to say the efficiency of converting electrical energy into light energy) is much better than for an incandescent lamp, some of the energy is nevertheless converted into heat. In the case of compact luminous devices, this heat builds up and rapidly raises the temperature inside the device.

**The term "PMMA" denotes** a methyl methacrylate (MMA) homopolymer or a copolymer comprising from 80 to 99.5% by weight of methyl methacrylate and from 0.5 to 20% by weight of at least one monomer having at least one ethylenic unsaturation that can copolymerize with methyl methacrylate. These monomers are well known and mention may be made, in particular, of styrene, alpha-methylstyrene, acrylic and methacrylic acids and alkyl-(meth)acrylates in which the alkyl group has from 2 to 4 carbon atoms. As examples, mention may be made of methyl acrylate and ethyl, butyl or 2-ethylhexyl (meth)acrylate.

Advantageously, this is a methyl methacrylate homopolymer or a copolymer comprising, by weight, 90 to 99.7%, preferably 90 to 99.5%, of methyl methacrylate and 0.3 to 10%, preferably 0.5 to 10%, of at least one monomer having at least one ethylenic unsaturation that can be copolymerized with methyl methacrylate. Preferably, the comonomer is methyl acrylate or ethyl acrylate.

PMMA is a transparent plastic appreciated in particular because it possesses excellent ageing resistance, especially resistance to ultraviolet radiation, and good scratch resistance.

The PMMA may contain an impact modifier, which improves the impact resistance thereof. The impact modifier is in the form of fine particles having an elastomer core and at least one thermoplastic shell, the size of the particles being in general less than 1 μm and advantageously between 50 and 300 nm. The impact modifier is prepared by emulsion polymerization. The impact modifier content in the PMMA is between 0 and 20%, preferably between 0 and 10%, by weight.

The core may for example consist of:

- an isoprene or butadiene homopolymer; or
- isoprene copolymers with at most 30 mol% of a vinyl monomer; or
- butadiene copolymers with at most 30 mol% of a vinyl monomer.

The vinyl monomer may be styrene, an alkyl styrene, acrylonitrile or an alkyl(meth)acrylate.

The core may also consist of:

- an alkyl(meth)acrylate homopolymer; or
- copolymers of an alkyl(meth)acrylate with at most 30 mol% of a monomer chosen from another alkyl(meth)acrylate and a vinyl monomer.

The alkyl(meth)acrylate is advantageously butyl acrylate. The vinyl monomer may be styrene, an alkyl styrene, acrylonitrile, butadiene or isoprene.

Advantageously, the core may be completely or partly crosslinked. It is sufficient to add at least difunctional monomers during the preparation of the core. These monomers may be chosen from poly(meth)-acrylic esters of polyols, such as butylene di(meth)-acrylate and trimethylolpropane trimethacrylate. Other difunctional monomers may for example be divinylbenzene, trivinylbenzene, vinyl acrylate and vinyl methacrylate. The core may also be crosslinked by introducing into it, by grafting or as comonomer during the polymerization, unsaturated functional monomers such as unsaturated carboxylic acid anhydrides, unsaturated carboxylic acids and unsaturated epoxides. As examples, mention may be made of maleic anhydride, (meth)acrylic acid and glycidyl methacrylate.

The shell or shells are styrene, alkyl styrene or methyl methacrylate homopolymers or copolymers containing at least 70 mol% of one of these monomers mentioned above and at least one comonomer chosen from the other monomers mentioned above, another alkyl-(meth)acrylate, vinyl acetate and acrylonitrile. The shell may be functionalized by introducing thereinto, by grafting or as comonomer during polymerization, unsaturated functional monomers such as unsaturated carboxylic acid anhydrides, unsaturated carboxylic acids and unsaturated epoxides. As examples, mention may be made of maleic anhydride, (meth)acrylic acid and glycidyl methacrylate.

As examples of impact modifiers, mention may be made of core-shell copolymers having a polystyrene shell and core-shell copolymers having a PMMA shell. There are also core-shell copolymers having two shells, one made of polystyrene and the other on the outside made of PMMA. Examples of impact modifiers and their method of preparation are described in the following patents: US 4 180 494, US 3 808 180, US 4 096 202, US 4 260 693, US 3 287 443, US 3 657 391, US 4 299 928, US 3 985 704 and US 5 773 520.

Advantageously, the core represents 70 to 90% and the shell 30 to 10% by weight of the impact modifier.

The impact modifier may be of the soft/hard type. As an example of an impact modifier of the soft/hard type, mention may be made of that consisting:

(i) of 75 to 80 parts of a core comprising at least 93 mol% of butadiene, 5 mol% of styrene and 0.5 to 1 mol% of divinylbenzene and
(ii) of 25 to 20 parts of two shells essentially of the same weight, the inner one made of polystyrene and the other outer one made of PMMA.

As another example of a soft/hard type impact modifier, mention may be made of that having a poly(butyl acrylate) or butyl acrylate/butadiene copolymer core and a PMMA shell.

The impact modifier may also be of the hard/soft/hard type, that is to say it contains, in this order, a hard core, a soft shell and a hard shell. The hard parts may consist of the polymers of the shell of the above soft/hard copolymers and the soft part may consist of the polymers of the core of the above soft/hard copolymers.

Mention may be made, for example, of an impact modifier of the hard/soft/hard type consisting:

(i) of a core made of a methyl methacrylate/ethyl acrylate copolymer;
(ii) of a layer made of a butyl acrylate/styrene copolymer;
(iii) of a shell made of a methyl methacrylate/ethyl acrylate copolymer.

The impact modifier may also be of the hard (core)/soft/semi-hard type. In this case the "semi-hard" outer shell consists of two shells, one being the intermediate shell and the other the outer shell. The intermediate shell is a copolymer of methyl methacrylate, styrene and at least one monomer chosen from alkyl acrylates, butadiene and isoprene. The outer shell is a PMMA homopolymer or copolymer.

An example of a hard/soft/semi-hard impact modifier is that consisting, in this order:

(i) of a core made of a methyl methacrylate/ethyl acrylate copolymer;
(ii) of a shell made of a butyl acrylate/styrene copolymer;
(iii) of a shell made of a methyl methacrylate/butyl acrylate/styrene copolymer; and
(iv) of a shell made of a methyl methacrylate/ethyl acrylate copolymer.

The PMMA may also contain at least one anti-UV additive that increases the lifetime of the PMMA. The PMMA may contain other additives that are well known to those skilled in the art. These may for example be an antistatic agent, a flame retarder, an antioxidant, etc.

The term **"polycarbonate (PC)"** denotes a polyester of carbonic acid, that is to say a polymer obtained by the reaction of at least one carboxylic acid derivative with at least one aromatic or aliphatic diol. The preferred aromatic diol is bisphenol A, which reacts with phosgene or else, by transesterification, with ethyl carbonate.

It may be a homopolycarbonate or copolycarbonate based on a diphenol of formula HO-Z-OH for which Z denotes a divalent organic radical possessing from 6 to 30 carbon atoms and containing one or more aromatic group (s). As examples, the diphenol can be:

- dihydroxybiphenyls,
- bis(hydroxyphenyl)alkanes,
- bis(hydroxyphenyl)cycloalkanes,
- indane bisphenols,
- bis(hydroxyphenyl) ethers,
- bis(hydroxyphenyl) ketones,
- bis(hydroxyphenyl) sulphones,
- bis(hydroxyphenyl) sulphoxides,
- $\alpha,\alpha'$-bis(hydroxyphenyl)diisopropylbenzenes.

It may also relate to derivatives of these compounds obtained by alkylation or halogenation of the aromatic ring. Mention will more particularly be made, among the compounds of formula HO-Z-OH, of the following compounds:

- hydroquinone,
- resorcinol,
- 4,4'-dihydroxybiphenyl,
- bis(4-hydroxyphenyl) sulphone,
- bis(3,5-dimethyl-4-hydroxyphenyl)methane,
- bis(3,5-dimethyl-4-hydroxyphenyl) sulphone,
- 1,1-bis(3,5-dimethyl-4-hydroxyphenyl)-para/metaisopropylbenzene,
- 1,1-bis(4-hydroxyphenyl)-1-phenylethane,
- 1,1-bis(3,5-dimethyl-4-hydroxyphenyl)cyclohexane,
- 1,1-bis(4-hydroxyphenyl)-3-methylcyclohexane,
- 1,1-bis(4-hydroxyphenyl)-3,3-dimethylcyclohexane,
- 1,1-bis(4-hydroxyphenyl)-4-methylcyclohexane,
- 1,1-bis(4-hydroxyphenyl)cyclohexane,
- 1,1-bis(4-hydroxyphenyl)-3,3,5-trimethylcyclohexane,
- 2,2-bis(3,5-dichloro-4-hydroxyphenyl)propane,
- 2,2-bis(3-methyl-4-hydroxyphenyl)propane,
- 2,2-bis(3,5-dimethyl-4-hydroxyphenyl)propane,
- 2,2-bis(4-hydroxyphenyl)propane (or bisphenol A),
- 2,2-bis(3-chloro-4-hydroxyphenyl)propane,
- 2,2-bis(3,5-dibromo-4-hydroxyphenyl)propane,
- 2,4-bis(4-hydroxyphenyl)-2-methylbutane,
- 2,4-bis(3,5-dimethyl-4-hydroxyphenyl)-2-methylbutane,
- $\alpha,\alpha'$-bis(4-hydroxyphenyl)-o-diisopropylbenzene,
- $\alpha,\alpha'$-bis(4-hydroxyphenyl)-m-diisopropylbenzene (or bisphenol M).

The preferred polycarbonates are the homopolycarbonates based on bisphenol A or 1,1-bis(4-hydroxyphenyl)-3,3,5-trimethylcyclohexane and the copolycarbonates based on bisphenol A and 1,1-bis(4-hydroxyphenyl)-3,3,5-trimethylcyclohexane.

The polycarbonates are produced by reaction of bisphenol(s) with phosgene in a homogeneous or interfacial process, or of diphenol(s) with a carbonate by transesterification. For further details, reference may be made to Schnell, "Chemistry and Physics of Polycarbonates", Interscience Publishers, 1964, or alternatively to "Polycarbonates" in Encyclopedia of Polymer Science and Engineering, Volume 11, 2nd edition, 1988, pages 648-718, and in U. Grigo, K. Kircher and P.R. Muller, "Polycarbonate", in the work Becker, Braun, Kunststoff-Handbuch, Volume 3/1, Polycarbonate, Polyacetale, Polyester, Cellulose-ester, Carl Hanser Verlag Munich, Vienna 1992, pages 117 to 299.

Polycarbonate is a transparent plastic appreciated especially because it possesses excellent impact strength and for its fire-retardant properties.

**Type of LED**

An LED is a light source that exploits the physical principle of electroluminescence, that is to say the emission of light by a semiconductor when a potential difference is applied to a junction of the p-n type. For further details, the reader may refer to Ullmann's Encyclopaedia of Industrial Chemistry, Volume A9, 5th edition, "Electroluminescent Materials and Devices", pages 255-264 or to Chapter 7 of the work by S.M. Sze "Modern Semiconductor Device Physics" published by Wiley (ISBN: 0471152374) in 1997. The LED therefore comprises the semiconductor itself and also other elements for the operation and handling of the LED, such as a transparent protective shell, supply contacts (anode/cathode), optionally a dish that reflects the emitted light, etc. According to the invention, the scattering particles are not dispersed in the transparent protective shell but in the cover.

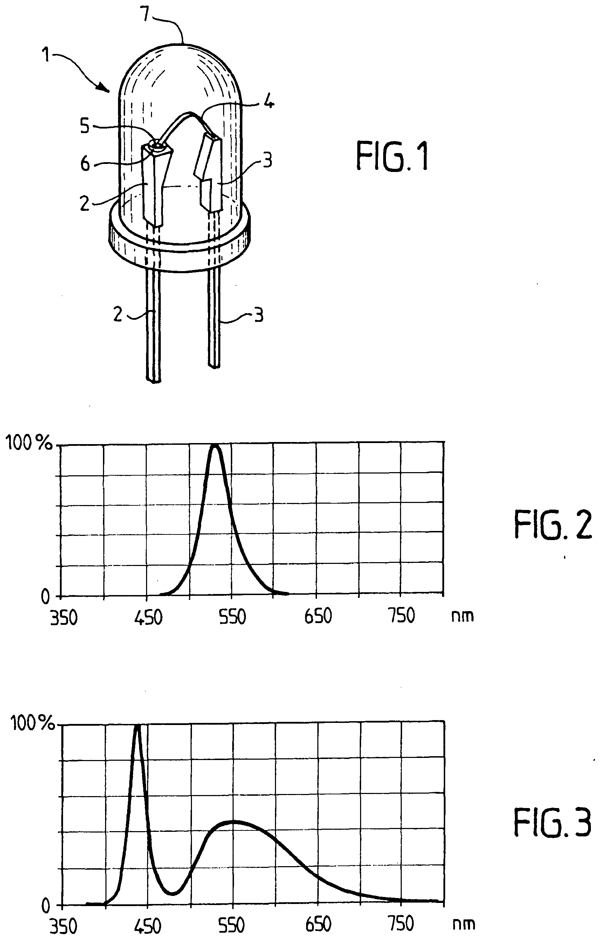

Among LEDs that emit in the visible spectrum, distinction may be made between colour LEDs and white LEDs. The emission spectrum of a colour LED is very narrow and has a mid-height width of between 30 and 55 nm, preferably between 30 and 50 nm (as may be seen in Figure 2). The emission spectrum depends on the nature of the p-n junction, and therefore on the chemical nature of material used for the semiconductor. Unlike another light source, such as an incandescent lamp or a neon lamp, the following equation connects the wavelength $\lambda$ (in nm) of the emitted light to the bandgap $E_{band}$ (in eV), which depends on the semiconductor material used:

$$\lambda = \frac{hc}{E_{band}}$$

where c denotes the velocity of light ($3 \times 10^8$ m/s) and h denotes Planck's constant ($4.136 \times 10^{-15}$ eV/s).

For example, if the semiconductor material is gallium arsenide GaAs, the bandgap is 1.35 eV and the LED emits in the near infrared at around 920 nm. Gallium phosphide arsenide GaAsP, gallium phosphide GaP, gallium nitride GaN and gallium indium nitride GaInN are other examples among other intermetallic compounds that can be used for manufacturing an LED.

The emission of white light by an LED is more problematic as it is necessary to combine the three essential components of white light, namely blue, red and green. It is also necessary to mix these three components so as to obtain a white light having good colour rendition or CRI and a good colour temperature (in kelvin). At the present time, there are at least three technologies for obtaining emission of white light:

- the first consists in combining an LED emitting in the blue with one or more phosphorescent compounds that reemit in the yellow. This is a method that is widely used at the present time, but the CRI (colour rendition index) is poor, less than 75, and there is often a halo problem due to the fact that the blue light and the re-emitted yellow light do not mix everywhere uniformly;
- the second consists in combining an LED emitting in the ultraviolet with one or more phosphorescent compounds, each re-emitting light in a given colour. An example of a white LED using this technology is given in document US 6 084 250. For example, an LED emitting between 370 and 410 nm is combined with a mixture of phosphorescent compounds, namely $Eu:BaMgAl_{11}O_{17}$, Cu:ZnS and $YVO_4$. This type of LED gives a white light having a good CRI, close to that of fluorescent lamps; and

- the third consists in mixing the colours emitted by several colour LEDs so as to obtain a white light. This technique has the advantage of being more flexible as it does not require the use of phosphorescent compounds. It is possible, by acting separately on the intensity of the LEDs, for the colour temperature to be finely adjusted, thereby making it possible to obtain a whole range of white lights (ranging from "hot" white to cold blue-white). In practice, to obtain white light, it is necessary for the LEDs to emit monochromatic light corresponding the sensitivity maxima of each type of cone present in the human eye (450 nm in the case of blue, 550 nm in the case of green and 620 nm in the case of red). If LEDs emitting at this precise frequency are not available, compensation is necessary by adjusting the emission intensity.

The emission spectra of white LEDs are broader than those of colour LEDs (as is visible in Figure 3). In the case of white LEDs, the scattering plastic according to the invention makes it possible to eradicate the drawbacks associated with the three technologies, for example the halo phenomenon associated with the first technology or else the imperfect colour mixing of the third technology. The scattering plastic according to the invention is therefore well suited to the production of luminous devices incorporating one or more white LEDs.

White LEDs, which have a high luminous flux, of greater than 3 Lm, may be profitably employed as a light source in illuminated signs. Thanks to their long lifetime, the LEDs do not have to be frequently replaced, this being a major advantage, most particulary in the case of illuminated signs that are located high up, for example at the top of towers or buildings. Another advantage is that the LEDs are small light sources, thereby making it possible to manufacture illuminated signs that are more compact, and therefore easier to mount and to dismantle.

## Scattering particles

To scatter the light emitted by the LED, the scattering particles must have a mean diameter of between 0.5 and 100 $\mu$m, advantageously between 1 and 80 $\mu$m and preferably between 1 and 70 $\mu$m. It is also necessary for the difference between the refractive indices (measured according to ASTM D 542) of the scattering particles and of the transparent plastic to be greater than 0.02 and preferably between 0.02 and 1.

The scattering particles may be of organic or mineral type and may advantageously be chosen from the families described below. The content of scattering particles is between 0.3 and 5%, preferably between 0.3 and 4%.

**Polyamide particles**

Among organic scattering particles, mention may be made of polyamide particles such as those described, for example, in Application EP 0 893 481. As polyamide, it is possible to use those obtained from lactams, such as for example ε-caprolactam, oenantholactam and undecanolactam, or from amino acids having from 4 to 20 carbon atoms, such as aminocaproic, 7-aminoheptanoic, 11-aminoundecanoic and 12-aminododecanoic acids. It is also possible to use products resulting from the condensation of diamines, such as hexamethylenediamine, dodecamethylenediamine, metaxylylenediamine and trimethylhexamethylenediamine, with dicarboxylic acids, such as isophthalic, terephthalic, adipic, suberic, azelaic, sebacic, dodecanedioic and dodecanedicarboxylic acids. For example, mention may be made of the polyamides nylon-6,6, nylon-6,9, nylon-6,10 and nylon-6,12, which are products resulting from the condensation of hexamethylenediamine with adipic acid, azelaic acid, sebacic acid and 1,12-dodecanedioic acid, respectively, or else nylon-9,6, which is a product resulting from the reaction of nonamethylenediamine with adipic acid.

Among these polyamides, mention may most particularly be made of nylon-6, obtained by the polymerization of ε-caprolactam, nylon-11, obtained by the condensation of 11-aminoundecanoic acid, and nylon-12, obtained by the polycondensation of 12-aminododecanoic acid or dodecanolactam.

The polyamide particles may be obtained by milling granules or by hot dissolution in suitable solvents followed by precipitation and cooling. It is also possible to obtain polyamide particles directly by anionic polymerization, as taught in documents EP-B1-192 515 or EP-B1-303 530. The polyamide powder obtained by the method described in EP-B1-303 530 is particularly preferred.

Suitable polyamide particles are for example those sold by Arkema under the names RILSAN or ORGASOL. For example, they may be particles of ORGASOL® 2001 EX D NAT 1 (nylon-12 particles with a mean diameter of 10 μm ± 1.5 μm), ORGASOL® 2001 UD NAT 1 (nylon-12 particles with a mean diameter of 5 μm ± 1 μm) or ORGASOL® 3501 EX D NAT 1 (6/12 copolyamide particles with a mean diameter of 10 μm ± 3 μm), and a melting point of 142 ± 2°C).

**PTFE particles**

Among organic scattering particles, mention may be made of polytetrafluoroethylene (PTFE) particles such as those described in Internal Application WO 01/66644. These particles may be obtained by a suspension or emulsion polymerization process. Suitable PTFE particles are for example those sold by DuPont under the name ZONYL. For example, it may be ZONYL 1000 (PTFE with a mean diameter of 11 μm) or ZONYL 1200 (PTFE with a mean diameter of 4 μm). The refractive index of PTFE is 1.376 according to the Polymer Handbook published by Wiley Interscience.

One advantage of PTFE particles is that they possess a high melting point (around 320°C) so that they can be introduced into the transparent plastic in the melt state, that is to say at high temperatures, possibly above 250°C.

**Crosslinked styrene-based particles**

Among organic scattering particles, mention may be made of particles of a crosslinked polymer comprising at least 50% styrene and 0.5 to 20%, preferably 1 to 10%, of a monomer possessing at least two double bonds C=C acting as crosslinking agent. This may for example be 1,4-butanediol di(meth)acrylate, ethylene glycol di(meth)acrylate, tetraethylene glycol di(meth)-acrylate, propylene glycol di(meth)acrylate, pentaerythritol tetra(meth)acrylate, allyl methacrylate or divinylbenzene.

The styrene-based crosslinked polymer advantageously comprises 0 to 20% of a comonomer having at least one ethylenic unsaturation copolymerizable with styrene, chosen for example from chlorostyrene, bromostyrene, vinyltoluene, acrylonitrile, alpha-methylstyrene or a $C_1$-$C_{10}$ alkyl(meth)acrylate such as, for example, methyl (meth)acrylate, ethyl (meth)acrylate, butyl (meth)-acrylate, benzyl (meth)acrylate, 2-hydroxyethyl (meth)-acrylate, phenyl (meth)acrylate, etc. Chlorostyrene and bromostyrene are the two monomers of choice for modifying the refractive index of the styrene-based crosslinked particles.

Crosslinking makes it possible to prevent the particles from deforming when they are incorporated into the transparent plastic.

The styrene-based scattering particles are advantageously prepared by polymerization in a dispersed medium, such as suspension, emulsion or microsuspension polymerization. The styrene-based scattering particles are substantially spherical.

Suitable styrene-based scattering particles are for example those sold by Sekisui under the name SBX. They may be for example SBX-6, SBX-8, SBX-12 or SBX-17 particles (styrene-based crosslinked particles with a mean diameter of 6, 8, 12 or 17 μm). The refractive index of the SBX particles is 1.59 (according to the information found on the Internet site of the Sekisui group).

**Methyl-methacrylated-based crosslinked particles**

Among organic scattering particles, mention may be made of particles of a crosslinked polymer comprising at least 50% methyl methacrylate and 0.5 to 20%, preferably 1 to 10%, of a monomer possessing at least two C=C double bonds acting as crosslinking agent. This may for example be 1,4-butanediol di(meth)acrylate, ethylene glycol di(meth)acrylate, tetraethylene glycol di(meth)acrylate, propylene glycol di(meth)acrylate, pentaerythritol tetra(meth)acrylate, allyl methacrylate or divinylbenzene.

The crosslinked polymer based on methyl methacrylate advantageously includes from 0 to 20% of a comonomer having at least one ethylenic unsaturation copolymerizable with methyl methacrylate, chosen from styrene, alpha-methylstyrene, acrylonitrile, a $C_1$-$C_{10}$ alkyl(meth)acrylate, such as for example methyl acrylate, ethyl (meth)acrylate, butyl (meth)acrylate, benzyl (meth)acrylate, 2-hydroxyethyl (meth)acrylate and phenyl (meth)acrylate. Styrene, $\alpha$-methylstyrene, benzyl methacrylate and phenyl methacrylate are monomers of choice for modifying the refractive index of the methyl-methacrylate-based particles.

The methyl-methacrylate-based scattering particles are advantageously prepared by polymerization in a dispersed medium, such as suspension polymerization, according to a recipe given for example in the document EP 1 022 115, US 2002/0123565 or US 2002/0123563. The methyl-methacrylate-based scattering particles are substantially spherical.

The following examples describe methyl-methacrylate-based scattering particles that are obtained by suspension polymerization:

Example 1

- 95% methyl methacrylate; 4% ethyl acrylate; 1% allyl methacrylate;
- mean diameter: 30 $\mu$m, with 90% of the particles having a mean diameter of less than 40 $\mu$m;
- refractive index $n_D$: 1.4935 (according to ASTM D 542).

Example 2

- 74% methyl methacrylate; 25% styrene; 1% allyl methacrylate;
- mean diameter: 30 $\mu$m, with 90% of the particles having a mean diameter of less than 40 $\mu$m;
- refractive index $n_D$: 1.5217 (according to ASTM D 542).

Example 3

- 55% methyl methacrylate; 40% benzyl methacrylate;

- 5% allyl methacrylate;
- mean diameter: 7 $\mu$m, with 90% of the particles having a mean diameter of less than 10 $\mu$m.

**Silicone particles**

Among organic scattering particles, mention may also be made of silicone-based particles. These particles are obtained by milling a silicone until scattering particles are obtained that have the size sufficient to be dispersed in the transparent plastic and to correctly scatter the light emitted by the LED. The silicone is obtained by the hydrolysis and condensation of chlorosilanes, such as dimethyldichlorosilane, diphenyldichlorosilane, phenylmethyldichlorosilane, trimethyltrichlorosilane or phenyltrichlorosilane. Preferably, the silicone will have been crosslinked by means of a free radical generator, such as for example benzoyl peroxide, para-chlorobenzoyl peroxide, *tert*-butyl peroxide or tert-amyl peroxide.

Suitable scattering silicone particles are for example those sold by Toray Dow Corning Silicone under the name TORAY-FIL DY33-719. These particles have a refractive index of 1.42 and a mean size of 2 $\mu$m.

**Mineral particles**

Among mineral scattering particles, mention may be made of $BaSO_4$, $TiO_2$, ZnO, $CaCO_3$, MgO and $Al_2O_3$ particles. Mineral scattering particles having a mean diameter of between 0.5 and 15 $\mu$m, preferably between 0.5 and 10 $\mu$m, are preferred. The advantage of mineral scattering particles over organic scattering particles is that it is possible to obtain good light scattering with a smaller amount. Typically, a content of mineral scattering particles of between 0.3 and 5%, rather between 0.3 and 4% and preferably between 0.3 and 2% is used. The mineral scattering particles are preferably colourless.

Another advantage of mineral scattering particles is associated with their thermal stability. This is because, if the scattering particles are mixed with the transparent plastic in the melt state, it is necessary to reach high values in order to melt the plastic and facilitate homogenization. For example, in the case of PMMA, homogenization is carried out at temperatures between 270 and 300°C. The organic scattering particles are liable to degrade at high temperature and result in yellowing/blackening of the particles. This detracts from the final appearance of the compound.

From the mineral scattering particles it is advantageous to choose $BaSO_4$ particles (1.64 refractive index $n_D$) as they scatter the light very well, are very easily dispersed in the transparent plastic and are perfectly colourless. In the case of the process for manufacturing cast PMMA, $BaSO_4$ particles are dispersed very well in the composition to be cured and do not aggregate therein. As an example, Blanc Fixe N particles sold by the German company Sachtleben Chemie may be used.

Other mineral particles are hollow glass microspheres, as described in International Application WO 03/072645. For example, glass microspheres sold under the name SCOTCHLITE® by 3M (Minnesota Mining and Manufacturing Company) may be suitable. These microspheres are obtained by known methods. According to EP 1 172 341, it is possible to add, for example, an inflammable liquid to a compound containing ingredients suitable for the preparation of glass and a blowing agent, and then to subject the entire composition to wet milling so as to obtain a dispersion of particles having a mean size of 3 $\mu$m. This slurry is then atomized by means of a two-fluid nozzle, at a pressure of between 0.2 and 2 MPa, so as to form droplets. Heating these droplets results in the formation of hollow glass microspheres. As ingredients suitable for preparing the glass, mention may be made of silica sand, volcanic ash, perlite, obsidian, silica gel, zeolite, bentonite, borax, boric acid, $Ca_3(PO)_4$, $Na_2SO_4$, $Mg_4P_2O_7$, $Al_2O_3$, a compound deriving from $SiO_2$, $B_2O_3$ or $Na_2O$. It is preferred to use a glass based on borosilicates, especially a soda-lime glass. The blowing agent generates gas when the mix of ingredients resulting in the glass undergoes vitrification by heating, and has the effect of producing substantially spherical hollow particles of molten vitrified glass. The blowing agent may for example be sodium, potassium, lithium, calcium, magnesium, barium, aluminium or zinc sulphate, carbonate, nitrate or acetate.

## Dyes

It is possible to add one or more dyes or pigments to the transparent plastic in order to obtain a coloured or tinted cover. A person skilled in the art knows how to choose the dye(s) or pigment(s) needed to obtain a given colour or tint, having a luminosity of less than 40, preferably less than 35. As examples of dyes and pigments, mention may be made of the following: copper phthalocyanine green, copper phthalocyanine blue, ultramarine blue, pyrazolone yellow, diketopyrrolopyrrole red, red iron oxide, ultramarine, chromium-titanium yellow, and dyes of the anthraquinone type.

## Surface roughness

At least one of the faces of the cover may have a relatively pronounced surface roughness (producing what is often called a "frosted" effect). The surface roughness may be obtained in several ways. According to a 1st method, in the case of a cast sheet, the glass mould, which forms the sheet, has itself a surface roughness that has been obtained by treating the glass of the mould, for example with hydrofluoric acid. According to a 2nd method, sandblasting may be used as taught in document WO 03/083564 or US 3 497 981. The surface roughness, denoted by Ra, is expressed in microns and can be measured using a roughness meter (for example of the Talysurf Surtronic 3P brand from Rank-Taylor-Hobson) according to the ISO 4287 and ISO 4288 standards. The value of the surface roughness Ra is of the order of a few $\mu$m. This value is between 0.5 and 4 $\mu$m, preferably between 1 and 3 $\mu$m.

The surface roughness on at least one of the faces of the cover allows the light-scattering effect of the scattering particles to be enhanced, or even allows the quantity of scattering particles to be reduced.

The faces of the cover according to the invention may also be perfectly smooth and not have any pronounced roughness. In this case, the value of the surface roughness Ra is less than 400 nm, advantageously less than 300 nm and preferably less than 100 nm.

## Method of obtaining the cover

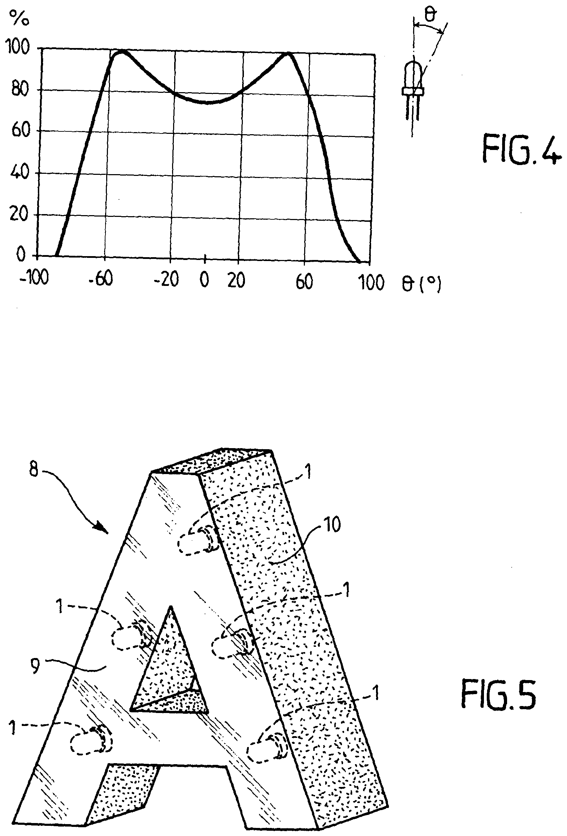

There are several methods known to those skilled in the art for producing the cover of the luminous device of the invention. The cover may have all kinds of geometries, depending on the nature of the intended application. For example, it may be in the form of a flat, curved or domed sheet, whether rectangular or circular, in the form of a disc, etc. It may also take the form of a letter of the alphabet or of any other similar element in the case of an illuminated sign, as illustrated for example in Figure 5. Examples are also given in the following documents: US 2004/0255497 **and** FR 2 857 434.

The cover has a thickness of between 0.1 and 15 cm, but is still between 0.1 and 10 cm, advantageously between 0.1 and 7 cm, preferably between 0.1 and 5 cm and even more preferably between 0.2 and 4 cm.

The scattering particles and optional other additives (dye(s), impact modifier, UV stabilizer, antioxidant, etc.) are mixed with the transparent plastic by means of an extruder or any other mixing tool suitable for thermoplastics as known to those skilled in the art. Recovered at the exit of the extruder are granules that are then formed to the desired shape using a conversion technique for thermoplastics. This may be injection moulding or compression moulding. It is also possible to adapt the extruder in order to produce a sheet. The cover is then obtained after forming the sheet to the desired shape after cutting and/or thermoforming.

In the case of PMMA, it is also possible to use the casting process to manufacture the sheet (then referred to as a cast PMMA sheet). This process consists in using a mould formed from two flat plates, for example made of inorganic glass, which are separated by a peripheral seal, generally made of polyvinyl chloride, for sealing between the two plates. The mould is closed by clamps placed along the sides. The composition to be polymerized (i.e. the methyl methacrylate and optionally the comonomer(s)), to which a polymerization initiator in sufficient amount has been added, is poured into the mould. The composition to be polymerized contains the scattering particles and all the other optional additives (for example demoulding agent, chain transfer agent for controlling the average molecular weight of the final polymer, antioxidant, UV stabilizer, dye(s), etc.). The polymerization is carried out or completed, depending on the case, by placing the mould in water (a process called "liquid pool" polymerization) or in an oven at the necessary temperature (40-80°C), and then in an oven (at about 100-130°C) for the post polymerization. The thickness of the seal determines the thickness of the polymer sheet obtained.

The cover has, when the LED is not lit, a luminosity L of less than 40, preferably less 35. This makes it possible to ensure good visibility of the sign during the daytime, when the LED is not lit.

## Examples

- a PMMA cover having a luminosity L of 23.7, an a* value of 0.3 and a b* value of -0.8;
- a PMMA cover having a luminosity L of 35.5, an a* value of -0.5 and a b* value of -1.5;
- a PMMA cover having a luminosity L of 34.1, an a* value of -18.8 and a b* value of -0.1;
- a PMMA cover having a luminosity L of 34.6, an a* value of 3.1 and a b* value of -32.7; and
- a PMMA cover having a luminosity L of 33.2, an a* value of 8.5 and a b* value of -28.2.

The three values L, a*, b* are used to characterize the principal colour in the CIELAB system. L denotes the luminosity and extends from 0 (black) to 100 (white). The value a* measures the red and green of the colour: the colours tending toward green have a negative a* value while those tending toward the red have a positive a* value. The b* value measures the blue and the yellow of the colour: colours tending toward the yellow have a positive b* value while those tending toward the blue have a negative b* value. The L, a*, b* values are measured using a colorimeter (especially according to the ASTM E 308 standard).

When the LED is lit (for instance with the Luxeon star LXHL-LM1D white LED having a flux > 5 Lm placed at a distance 9 cm from the surface of the sheet), the L, a* and b* values are determined by comparing the colour of the cover with a control specimen which has a substantially identical colour and which is itself not lit. Thus, when the colour of the lit cover is substantially identical to that of the unlit control specimen, it is possible to deduce therefrom the L, a* and b* values of the lit cover knowing those of the control specimen.

When the LED is lit, the cover has a luminosity L of greater than 55, an a* value of between -5 and +5 and a b* value of between -5 and +5. Advantageously, the luminosity is greater than 55, the a* value is between -3.5 and +3.5 and the b* value is between -3.5 and +3.5. Preferably, the luminosity is greater than 65, the a* value is between -3.5 and +3.5 and the b* value is between -3.5 and +3.5.

## Luminous device

The luminous device according to the invention comprises at least one white LED, the light flux of which is greater than 3 Lm, advantageously greater than 5 Lm, preferably greater than 10 Lm, more preferably greater than 50 Lm, and at least one cover made of a transparent plastic in which 0.5 to 3% of scattering particles are dispersed. The cover makes it possible to:

- ensure transmission of the light emitted by the LED (s) ;
- mask and protect the LED(s);
- provide a uniform and nondazzling illumination;
- reduce, or even eliminate, the drawbacks of LEDs, especially the halo effects in white LEDs; and
- ensure good visibility both in the daytime and at night.

The cover is in the form of a single layer and is not obtained by coextrusion of two or more layers as in EP 1369224 A1.

Advantageously, the luminous flux is between 3 and 200 Lm, better still between 3 and 100 Lm, preferably between 5 and 100 Lm, even more preferably between 10 and 100 Lm and very preferentially between 50 and 100 Lm.

Thanks to white LEDs having a high luminous flux, it is possible to reduce the number of LEDs in order to obtain a given illumination. Compared with an incandescent lamp or a neon tube, it is possible to obtain luminous devices that are more compact and consume less electrical power. In addition, when the LED is lit, the cover appears to be substantially white and has, as L, a*, b* values, a luminosity of greater than 55, an a* value of between -7.5 and +7.5 and a b* value of between - 7.5 and +7.5

### Example of a white LED

It is possible, for example, to envisage using a white LED of the LUXEON STAR type sold by Lumileds. It is also possible to envisage using a white LED sold by Tridonic & co under the reference Daylight P115-BL, which has a luminous flux of at least 27.7 Lm.

The cover is separated from the LED(s) by a distance of between 1 and 50 cm, better still between 2 and 50 cm, preferably between 2 and 20 cm and even more preferably between 3 and 20 cm. The luminous device is distinguished from edge-emitting devices, as described for example in EP 0 893 481. This is because, in the luminous device according to the invention, it is not the edge of the cover that is illuminated but one of the faces of the cover.

[Uses]

The luminous device according to the invention has a variety of applications such as, for example:

- interior lighting (living room lamps, office lamps, etc.);
- advertising displays;
- direction lighting or escape route marking;
- illuminated signs (in this case, the cover may especially have the form of a letter, a number, a symbol or any other sign);
- traffic signalling; and
- automobile lighting (for example the luminous device may be a headlamp, a daytime light, a direction indicator, a stop light, a fog lamp, reversing light, etc.)

The invention also relates to these uses.

## Claims

1. Luminous device comprising at least one white LED having a luminous flux of greater than 3 Lm, and a cover made of a transparent plastic in which scattering particles with a content of 0.3 to 5%, are dispersed and said cover is having, when the LED is off, a luminosity L of less than 40, and when the LED is lit, a luminosity L of greater than 55, an a* value of between -5 and +5 and a b* value of between -5 and +5, **characterized in that** the difference between the refractive indices, measured according to ASTM D-542, of the scattering particles and of the transparent plastic is greater than 0.02 and the three values L, a*, b* are used to characterize the principal colour in the CIELAB system and that the cover is in the form of a single layer and that the transparent plastic is chosen from crystal polystyrene, polyethylene terephthalate, a transparent, especially clarified, polyolefin, clarified polypropylene, PMMA, a transparent polyamide or polycarbonate and that the scattering particles are chosen from polyamide particles, PTFE particles, crosslinked styrene-based particles, methyl-methacrylate-based crosslinked particles or silicone particles or chosen from BaSO$_4$, TiO$_2$, ZnO, CaCO$_3$, MgO or Al$_2$O$_3$ particles or hollow glass microspheres.

2. Luminous device according to Claim 1, **characterized in that** the transparent plastic is of the thermoplastic or thermosetting type and has a light transmission in the visible range of at least 50%, according to the DIN 67-507 standard.

3. Luminous device according to either of Claims 1 and 2, **characterized in that** the transparent plastic is chosen from PMMA or polycarbonate.

4. Luminous device according to either of Claims 1 and 2, **characterized in that** the transparent plastic is a methyl methacrylate homopolymer or a copolymer comprising from 80 to 99.5% by weight of methyl methacrylate and from 0.5 to 20% by weight of at least one monomer having at least one ethylenic unsaturation that can copolymerize with methyl methacrylate.

5. Luminous device according to Claim 4, **characterized in that** the transparent plastic is a copolymer comprising, by weight, 90 to 99.7%, preferably 90 to 99.5%, of methyl methacrylate and 0.3 to 10%, preferably 0.5 to 10%, of at least one monomer having at least one ethylenic unsaturation that can be copolymerized with methyl methacrylate.

6. Luminous device according to either of Claims 1 and 2, **characterized in that** the transparent plastic is a polyester obtained by the reaction of at least one carboxylic acid derivative with at least one aromatic or aliphatic diol.

7. Luminous device according to Claim 6, **characterized in that** the polyester is a homopolycarbonate or a copolycarbonate based on a bisphenol of formula HO-Z-OH for which Z denotes a divalent organic radical possessing from 6 to 30 carbon atoms and containing one or more aromatic group(s).

8. Luminous device according to Claim 7, **characterized in that** the diphenol is chosen from dihydroxydiphenyls, bis(hydroxyphenyl)alkanes, bis-(hydroxyphenyl)cycloalkanes, indane bisphenols, bis(hydroxyphenyl) ethers, bis(hydroxyphenyl) ketones, bis(hydroxyphenyl) sulphones, bis(hydroxyphenyl) sulphoxides and $\alpha,\alpha'$-bis(hydroxyphenyl)diisopropylbenzenes.

9. Luminous device according to one of the preceding claims, **characterized in that** the scattering particles have a mean diameter of between 0.5 and 100 $\mu$m.

10. Luminous device according to one of Claims 1 to 9, **characterized in that** the scattering particles are polyamide particles, PTFE particles, crosslinked styrene-based particles, methyl-methacrylate-based crosslinked particles or silicone particles.

11. Luminous device according to one of Claims 1 to 9, **characterized in that** the scattering particles are BaSO$_4$, TiO$_2$, ZnO, CaCO$_3$, MgO or Al$_2$O$_3$ particles or hollow glass microspheres.

12. Luminous device according to Claim 11, **characterized in that** the mean diameter of the mineral scattering particles is between 0.5 and 15.

13. Luminous device according to either of Claims 11 and 12, **characterized in that** the content of scattering particles is between 0.3 and 4%.

**14.** Luminous device according to one of Claims 1 to 13, **characterized in that** at least one of the faces of the cover has a roughness Ra of between 0.5 and 4 μm.

**15.** Use of the luminous device according to any one of Claims 1 to 14 for :

- interior lighting;
- advertising displays;
- direction lighting or escape route marking;
- illuminated signs ;
- traffic signalling; and
- automobile lighting.

**16.** Use according to Claim 15 **characterized in that** the cover has the form of a letter or a number.

**17.** Use according to Claim 15, **characterized in that** the automobile lighting is a headlamp, a daytime light, a direction indicator, a stop light, a fog lamp or a reversing light.


**Patentansprüche**

**1.** Leuchtvorrichtung, umfassend wenigstens eine weiße LED mit einem Lichtstrom von größer als 3 lm und eine Abdeckung aus einem transparenten Kunststoff, in dem streuende Partikel mit einem Gehalt von 0,3 bis 5 % dispergiert sind, und wobei die Abdeckung, wenn die LED ausgeschaltet ist, eine Helligkeit L von weniger als 40 aufweist, und wenn die LED leuchtet, eine Helligkeit L von größer als 55, einen a*-Wert von zwischen -5 und +5 und einen b*-Wert von zwischen -5 und +5 aufweist, **dadurch gekennzeichnet, dass** der Unterschied zwischen den Brechungsindizes, gemessen gemäß ASTM D-542, der streuenden Partikel und des transparenten Kunststoffs größer als 0,02 ist und die drei Werte L, a* und b* verwendet werden, um die Hauptfarbe nach dem CIELAB-System zu charakterisieren, und dass die Abdeckung in der Form einer einzelnen Schicht vorliegt, und dass der transparente Kunststoff ausgewählt ist aus kristallinem Polystyrol, Polyethylenterephthalat, einem transparenten, insbesondere geklärten, Polyolefin, geklärtem Polypropylen, PMMA, einem transparenten Polyamid oder Polycarbonat, und dass die streuenden Partikel ausgewählt sind aus Polyamidpartikeln, PTFE-Partikeln, Partikeln auf der Basis von vernetztem Styrol, vernetzten Partikeln auf Methylmethacrylatbasis und Siliconpartikeln oder ausgewählt sind aus $BaSO_4$-, $TiO_2$-, ZnO-, $CaCO_3$-, MgO- oder $Al_2O_3$-Partikeln und hohlen Glas-Mikrokügelchen.

**2.** Leuchtvorrichtung gemäß Anspruch 1, **dadurch gekennzeichnet, dass** der transparente Kunststoff vom thermoplastischen oder wärmehärtenden Typ ist und eine Lichtdurchlässigkeit in dem sichtbaren Bereich von wenigstens 50 % gemäß dem Standard DIN 67-507 aufweist.

**3.** Leuchtvorrichtung gemäß einem der Ansprüche 1 und 2, **dadurch gekennzeichnet, dass** der transparente Kunststoff ausgewählt ist aus PMMA oder Polycarbonat.

**4.** Leuchtvorrichtung gemäß einem der Ansprüche 1 und 2, **dadurch gekennzeichnet, dass** der transparente Kunststoff ein Methylmethacrylat-Homopolymer oder ein Copolymer ist, das von 80 bis 99,5 Gew.-% Methylmethacrylat und von 0,5 bis 20 Gew.-% an wenigstens einem Monomer mit wenigstens einer ethylenischen Unsättigung, das mit Methylmethacrylat copolymerisieren kann, umfasst.

**5.** Leuchtvorrichtung gemäß Anspruch 4, **dadurch gekennzeichnet, dass** der transparente Kunststoff ein Copolymer ist, das von 90 bis 99,7 Gew.-%, vorzugsweise 90 bis 99,5 Gew.-%, Methylmethacrylat und von 0,3 bis 10 Gew.-%, vorzugsweise 0,3 bis 10 Gew.-%, an wenigstens einem Monomer mit wenigstens einer ethylenischen Unsättigung, das mit Methylmethacrylat copolymerisiert werden kann, umfasst.

**6.** Leuchtvorrichtung gemäß einem der Ansprüche 1 und 2, **dadurch gekennzeichnet, dass** der transparente Kunststoff ein Polyester ist, der durch die Umsetzung wenigstens eines Carbonsäurederivats mit wenigstens einem aromatischen oder aliphatischen Diol erhalten ist.

**7.** Leuchtvorrichtung gemäß Anspruch 6, **dadurch gekennzeichnet, dass** der Polyester ein Homopolycarbonat oder ein Copolycarbonat auf der Basis eines Bisphenols mit der Formel HO-Z-OH ist, wobei Z einen zweiwertigen organischen Rest darstellt, der von 6 bis 30 Kohlenstoffatome aufweist und eine oder mehrere aromatische Gruppe(n) enthält.

**8.** Leuchtvorrichtung gemäß Anspruch 7, **dadurch gekennzeichnet, dass** das Diphenol ausgewählt ist aus Dihydroxydiphenylen, Bis(hydroxyphenyl)alkanen, Bis(hydroxyphenyl)cycloalkanen, Indanbisphenolen, Bis(hydroxyphenyl)ethern, Bis(hydroxyphenyl)ketonen, Bis(hydroxyphenyl)sulfonen, Bis(hydroxyphenyl)sulfoxiden und $\alpha,\alpha'$-Bis(hydroxyphenyl)diisopropylbenzolen.

**9.** Leuchtvorrichtung gemäß einem der vorstehenden Ansprüche, **dadurch gekennzeichnet, dass** die streuenden Partikel einen mittleren Durchmesser von zwischen 0,5 und 100 μm aufweisen.

**10.** Leuchtvorrichtung gemäß einem der Ansprüche 1 bis 9, **dadurch gekennzeichnet, dass** die streuenden Partikel Polyamidpartikel, PTFE-Partikel, Partikel auf der Basis von vernetztem Styrol, vernetzte Partikeln auf Methylmethacrylatbasis oder Siliconpartikel sind.

**11.** Leuchtvorrichtung gemäß einem der Ansprüche 1 bis 9, **dadurch gekennzeichnet, dass** die streuenden Partikel $BaSO_4$-, $TiO_2$-, ZnO-, $CaCO_3$-, MgO- oder $Al_2O_3$-Partikel oder hohle Glas-Mikrokügelchen sind.

**12.** Leuchtvorrichtung gemäß Anspruch 11, **dadurch gekennzeichnet, dass** der mittlere Durchmesser der mineralischen streuenden Partikel zwischen 0,5 und 15 beträgt.

**13.** Leuchtvorrichtung gemäß einem der Ansprüche 11 und 12, **dadurch gekennzeichnet, dass** der Gehalt an streuenden Partikeln zwischen 0,3 und 4 % beträgt.

**14.** Leuchtvorrichtung gemäß einem der Ansprüche 1 bis 13, **dadurch gekennzeichnet, dass** wenigstens eine der Seiten der Abdeckung eine Rauigkeit Ra von zwischen 0,5 und 4 $\mu$m aufweist.

**15.** Verwendung der Leuchtvorrichtung gemäß einem der Ansprüche 1 bis 14 für:

- Innenbeleuchtung;
- Werbeanzeigen;
- Richtungsanzeige oder Fluchtwegkennzeichnung;
- beleuchtete Kennzeichen;
- Verkehrssignale; und
- Automobilbeleuchtung.

**16.** Verwendung gemäß Anspruch 15, **dadurch gekennzeichnet, dass** die Abdeckung die Form eines Buchstabens oder einer Ziffer aufweist.

**17.** Verwendung gemäß Anspruch 15, **dadurch gekennzeichnet, dass** die Automobilbeleuchtung ein Frontscheinwerfer, ein Tagfahrscheinwerfer, ein Richtungsanzeiger, ein Bremsscheinwerfer, ein Nebelscheinwerfer oder ein Rückfahrscheinwerfer ist.

**Revendications**

**1.** Dispositif lumineux comprenant au moins une DEL blanche ayant un flux lumineux de plus de 3 lm, et un couvercle fait d'un plastique transparent dans lequel des particules diffusantes avec une teneur de 0,3 à 5 % sont dispersées et ledit couvercle a, quand la DEL est arrêtée, une luminosité L de moins de 40, et quand la DEL est allumée, une luminosité L de plus de 55, une valeur a* comprise entre -5 et +5 et une valeur b* comprise entre -5 et +5, **caractérisé en ce que** la différence entre les indices de réfraction, mesurés selon la méthode ASTM D-542, des particules diffusantes et du plastique transparent est supérieure à 0,02 et les trois valeurs L, a*, b* sont utilisées pour caractériser la couleur principale dans le système CIELAB et **en ce que** le couvercle est sous la forme d'une seule couche et **en ce que** le plastique transparent est choisi parmi le polystyrène cristallin, le téréphtalate de polyéthylène, une polyoléfine transparente, en particulier clarifiée, le polypropylène clarifié, le PMMA, un polyamide transparent ou le polycarbonate et **en ce que** les particules diffusantes sont choisies parmi des particules de polyamide, des particules de PTFE, des particules à base de styrène réticulé, des particules réticulées à base de méthacrylate de méthyle ou des particules de silicone ou choisies parmi des particules de $BaSO_4$, $TiO_2$, ZnO, $CaCO_3$, MgO ou $Al_2O_3$ ou des microsphères de verre creuses.

**2.** Dispositif lumineux selon la revendication 1, **caractérisé en ce que** le plastique transparent est du type thermoplastique ou thermodurcissable et a une transmission lumineuse dans la gamme visible d'au moins 50 %, selon la norme DIN 67-507.

**3.** Dispositif lumineux selon l'une ou l'autre des revendications 1 et 2, **caractérisé en ce que** le plastique transparent est choisi entre le PMMA ou le polycarbonate.

**4.** Dispositif lumineux selon l'une ou l'autre des revendications 1 et 2, **caractérisé en ce que** le plastique transparent est un homopolymère de méthacrylate de méthyle ou un copolymère comprenant de 80 à 99,5 % en poids de méthacrylate de méthyle et de 0,5 à 20 % en poids d'au moins un monomère ayant au moins une insaturation éthylénique qui peut copolymériser avec le méthacrylate de méthyle.

**5.** Dispositif lumineux selon la revendication 4, **caractérisé en ce que** le plastique transparent est un copolymère comprenant, en poids, 90 à 99,7 %, de préférence 90 à 99,5 %, de méthacrylate de méthyle et 0,3 à 10 %, de préférence 0,5 à 10 %, d'au moins un monomère ayant au moins une insaturation éthylénique qui peut être copolymérisé avec le méthacrylate de méthyle.

**6.** Dispositif lumineux selon l'une ou l'autre des revendications 1 et 2, **caractérisé en ce que** le plastique transparent est un polyester obtenu par la réaction d'au moins un dérivé d'acide carboxylique avec au moins un diol aromatique ou aliphatique.

**7.** Dispositif lumineux selon la revendication 6, **caractérisé en ce que** le polyester est un homopolycarbonate ou un copolycarbonate basé sur un bisphénol de formule HO-Z-OH pour laquelle Z désigne un radical organique divalent possédant de 6 à 30 atomes de carbone et contenant un ou plusieurs groupes aromatiques.

**8.** Dispositif lumineux selon la revendication 7, **caractérisé en ce que** le diphénol est choisi parmi les dihydroxydiphényles, les bis(hydroxyphényl)alcanes, les bis (hydroxyphényl)cycloalcanes, les bisphénols d'indane, les bis(hydroxyphényl)éthers, les bis(hydroxyphényl)-cétones, les bis(hydroxyphényl)sulfones, les bis(hydroxyphényl)sulfoxydes et les $\alpha,\alpha$'-bis(hydroxyphényl)-diisopropylbenzènes.

**9.** Dispositif lumineux selon une des revendications précédentes, **caractérisé en ce que** les particules diffusantes ont un diamètre moyen compris entre 0,5 et 100 $\mu$m.

**10.** Dispositif lumineux selon une des revendications 1 à 9, **caractérisé en ce que** les particules diffusantes sont des particules de polyamide, des particules de PTFE, des particules à base de styrène réticulé, des particules réticulées à base de méthacrylate de méthyle ou des particules de silicone.

**11.** Dispositif lumineux selon une des revendications 1 à 9, **caractérisé en ce que** les particules diffusantes sont des particules de $BaSO_4$, $TiO_2$, ZnO, $CaCO_3$, MgO ou $Al_2O_3$ ou des microsphères de verre creuses.

**12.** Dispositif lumineux selon la revendication 11, **caractérisé en ce que** le diamètre moyen des particules diffusantes minérales se situe entre 0,5 et 15.

**13.** Dispositif lumineux selon l'une ou l'autre des revendications 11 et 12, **caractérisé en ce que** la teneur en particules diffusantes se situe entre 0,3 et 4 %.

**14.** Dispositif lumineux selon l'une des revendications 1 à 13, **caractérisé en ce qu'**au moins une des faces du couvercle a une rugosité Ra comprise entre 0,5 et 4 $\mu$m.

**15.** Utilisation du dispositif lumineux selon l'une quelconque des revendications 1 à 14 pour :

- l'éclairage intérieur ;
- les écrans publicitaires ;
- l'éclairage de directions ou le marquage d'issues de secours ;
- les enseignes lumineuses ;
- la signalisation du trafic ; et
- l'éclairage automobile.

**16.** Utilisation selon la revendication 15, **caractérisée en ce que** le couvercle a la forme d'une lettre ou d'un chiffre.

**17.** Utilisation selon la revendication 15, **caractérisée en ce que** l'éclairage automobile est un phare, un feu de croisement, un indicateur de direction, un feu stop, un phare antibrouillard ou un feu de recul.

FIG.1

FIG.2

FIG.3

FIG.4

FIG.5

FIG.6a

FIG.6b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6723772 B
- US 20040191550 A
- US 20040255497 A
- EP 1369224 A
- WO 03052315 A
- DE 10058348
- US 6084250 A
- DE 10308704
- US 4180494 A
- US 3808180 A
- US 4096202 A
- US 4260693 A
- US 3287443 A
- US 3657391 A
- US 4299928 A
- US 3985704 A
- US 5773520 A
- EP 0893481 A
- EP 192515 B1
- EP 303530 B1
- WO 0166644 A
- EP 1022115 A
- US 20020123565 A
- US 20020123563 A
- WO 03072645 A
- EP 1172341 A
- WO 03083564 A
- US 3497981 A
- FR 2857434
- EP 1369224 A1

**Non-patent literature cited in the description**

- **SCHNELL.** Chemistry and Physics of Polycarbonates. Interscience Publishers, 1964
- Polycarbonates. Encyclopedia of Polymer Science and Engineering. 1988, vol. 11, 648-718
- Polycarbonate. **U. GRIGO ; K. KIRCHER ; P.R. MULLER.** Kunststoff-Handbuch, Volume 3/1, Polycarbonate, Polyacetale, Polyester, Cellulose-ester. Carl Hanser Verlag Munich, 1992, vol. 3/1, 177-299
- Electroluminescent Materials and Devices. Ullmann's Encyclopaedia of Industrial Chemistry. vol. A9, 255-264
- **S.M. SZE.** Modern Semiconductor Device Physics. Wiley, 1997
- Polymer Handbook. Wiley Interscience